# EUROPÄISCHE PATENTANMELDUNG

(11) **EP 3 890 001 A1**
(43) Veröffentlichungstag der Anmeldung: **06.10.2021**
(21) Anmeldenummer: 21164903.3
(22) Anmeldetag: 25.03.2021
(51) Int. Cl.: H01L 21/48, H01L 23/373, H05K 3/00

(54) **VERFAHREN ZUR STEIGERUNG DER ELEKTRISCHEN FUNKTIONALITÄT UND/ODER LEBENSDAUER VON LEISTUNGSELEKTRONISCHEN MODULEN**

(30) Priorität: 30.03.2020 DE 102020204116
(71) Anmelder: Fraunhofer-Gesellschaft zur Förderung der angewandten Forschung e.V., 80686 München (DE)
(72) Erfinder: Bayer, Christoph Friedrich, 91058 Erlangen (DE); Schletz, Andreas, 91058 Erlangen (DE)
(74) Vertreter: Gagel, Roland

(57) **Zusammenfassung**

Bei einem Verfahren zur Steigerung der elektrischen Funktionalität und/oder Lebensdauer von leistungselektronischen Modulen wird der leistungselektronische Schaltungsträger (2) und/oder die auf dem leistungselektronischen Schaltungsträger (2) aufgebrachte Metallisierung (1) und/oder eine mit einer Rückseite des leistungselektronischen Schaltungsträgers (2) verbundene oder zu verbindende Bodenplatte (3) durch lokalen Materialabtrag mit wenigstens einem Laserstrahl fein strukturiert, um bei der Herstellung oder beim Betrieb des Moduls auftretende thermomechanische Spannungen zu verringern. In einer alternativen Ausgestaltung wird die vorderseitig auf dem leistungselektronischen Schaltungsträger (2) aufgebrachte Metallisierung (1) durch lokalen Materialabtrag mit Laserstrahlung strukturiert oder eine bereits erzeugte Struktur (10) verfeinert oder ergänzt, um eine vorgegebene elektrische Funktionalität der Metallisierung (1) zu erreichen.

## Beschreibung

### Technisches Anwendungsgebiet

Die vorliegende Erfindung betrifft ein Verfahren zur Steigerung der elektrischen Funktionalität und/oder Lebensdauer von leistungselektronischen Modulen, die ein oder mehrere Halbleiterbauelemente auf einer Vorderseite eines leistungselektronischen Schaltungsträgers (bspw. mit keramischer oder organischer Isolationsschicht oder einer Mischung daraus) aufweisen, das eine vorderseitig oder eine vorder- und rückseitig aufgebrachte Metallisierung trägt. Die Erfindung betrifft auch gemäß dem Verfahren ausgebildete leistungselektronische Module.

Leistungselektronische Module, wie sie beispielsweise als Umrichter, Wechselrichter, Transformatoren, Schaltnetzteile oder Verstärker zum Einsatz kommen, weisen in der Regel einen Schaltungsträger aus beispielsweise einem keramischen Substrat auf, das beidseitig mit einer metallischen Schicht bzw. Metallisierung versehen ist. Auf einer Vorderseite dieses Schaltungsträgers werden dann die für die jeweilige Anwendung erforderlichen Halbleiterbauelemente wie beispielsweise Leistungstransistoren, Dioden oder Leistungskondensatoren aufgebracht und elektrisch verschaltet. Der Schaltungsträger kann mit seiner Rückseite auch mit einer Bodenplatte verbunden werden, die als Wärmesenke zur Kühlung des Moduls ausgebildet sein kann.

Aufgrund der unterschiedlichen Wärmeausdehnungskoeffizienten der beim Aufbau eines leistungselektronischen Moduls eingesetzten Materialien, insbesondere des Substrates und der darauf aufgebrachten Metallisierung, verbiegen sich die Schaltungsträger durch die beim Befestigen, bspw. Auflöten, der Halbleiterbauelemente am Schaltungsträger oder des Schaltungsträgers auf der Bodenplatte auftretenden hohen Temperaturen und unterschiedlichen thermischen Ausdehnungskoeffizienten der verschiedenen Materialien. Auch beim Betrieb des leistungselektronischen Moduls, insbesondere bei einem Betriebsmodenwechsel (Lastwechsel) oder bei einem Wechsel der Umgebungsbedingungen, insbesondere einem Temperaturwechsel, tritt eine temperaturgetriebene Verformung des Leistungsmoduls auf, die eine der Hauptbeschränkungen der Lebensdauer darstellt, der thermo-mechanische Verschleiß.

Zur Verringerung der Verformungen und thermomechanischen Spannungen bei der Herstellung und/oder dem Betrieb leistungselektronischer Module ist es bekannt, durch Materialabtrag geeignete Strukturen in den Schaltungsträger einzubringen. Die Erzeugung dieser Strukturen erfolgt bisher über geeignete Ätzverfahren in der Regel in Randbereichen des Schaltungsträgers, um die elektrische Funktion des leistungselektronischen Moduls durch die geätzten Strukturen nicht zu beeinträchtigen. Auch die Strukturierung der vorderseitigen Metallisierung zur Ausbildung der gewünschten Leiterbahnen für die elektrische Verschaltung der Halbleiterbauelemente erfolgt in der Regel mit derartigen Ätzverfahren.

Ausgehend von dieser Problematik liegt der vorliegenden Erfindung die Aufgabe zugrunde, ein Verfahren anzugeben, mit dem sich die Lebensdauer und/oder die elektrische Funktionalität derartiger leistungselektronischer Module weiter steigern lässt.

### Darstellung der Erfindung

Die Aufgabe wird mit dem Verfahren gemäß Patentanspruch 1 gelöst. Die Patentansprüche 10 und 11 geben leistungselektronische Module an, die mit diesem Verfahren erhalten werden können. Vorteilhafte Ausgestaltungen des Verfahrens sowie der leistungselektronischen Module sind Gegenstand der abhängigen Patentansprüche oder lassen sich der nachfolgenden Beschreibung sowie den Ausführungsbeispielen entnehmen.

Das Verfahren betrifft leistungselektronische Module, die ein oder mehrere Halbleiterbauelemente auf einer Vorderseite eines leistungselektronischen Schaltungsträgers, bspw. eines keramischen Substrats, aufweisen, der eine vorderseitig oder eine vorder- und rückseitig aufgebrachte Metallisierung trägt. Unter der Vorderseite des Substrats bzw. Schaltungsträgers wird dabei die Seite verstanden, auf der die Halbleiterbauelemente aufgebracht werden. Die Rückseite entspricht der gegenüberliegenden Seite. Unter leistungselektronischen Modulen bzw. dem Begriff der Leistungselektronik werden dabei Systeme mit elektrischen Schaltungen verstanden, die mit Spannungen von ≥10 V und/oder Strömen von ≥10 A betrieben werden und eine entsprechend hohe Wärmebelastung aufweisen. Bei dem vorgeschlagenen Verfahren wird bei der Herstellung dieser leistungselektronischen Module bei einer ersten Verfahrensalternative der leistungselektronische Schaltungsträger und/oder die auf dem leistungselektronischen Schaltungsträger aufgebrachte Metallisierung und/oder eine mit der Rückseite des leistungselektronischen Schaltungsträgers verbundene oder zu verbindende Bodenplatte durch lokalen Materialabtrag mit wenigstens einem Laserstrahl strukturiert, um bei der Herstellung oder beim Betrieb des leistungselektronischen Moduls auftretende thermomechanische Spannungen (gegenüber einer Ausgestaltung ohne diese Strukturierung) zu verringern. Diese Verfahrensalternative erhöht somit durch Verringerung der thermomechanischen Spannungen die Lebensdauer des leistungselektronischen Moduls. Bei einer zweiten Verfahrensalternative, die auch in Kombination mit der ersten Verfahrensalternative durchgeführt werden kann, wird die vorderseitig auf dem leistungselektronischen Schaltungsträger aufgebrachte Metallisierung durch lokalen Materialabtrag mit wenigstens einem Laserstrahl strukturiert oder es wird eine bereits in der Metallisierung erzeugte Struktur durch den lokalen Materialabtrag mit dem Laserstrahl verfeinert oder ergänzt, um eine vorgegebene, ggf. zusätzliche, elektrische Funktionalität der Metallisierung zu erreichen.

Bei beiden Verfahrensalternativen werden somit ein oder mehrere Laserstrahlen eingesetzt, um die jeweiligen Strukturen im Schaltungsträger bzw. Substrat, der Metallisierung oder der Bodenplatte zu erzeugen. Diese lasergestützte subtraktive Bearbeitung kann beispielsweise mittels Ultra-Kurzpuls-Lasersystemen erfolgen. Hierbei wurde erkannt, dass durch eine Verfeinerung oder präzisere Ausbildung der bisher mittels Ätzverfahren erzeugten Strukturen zum einen die Lebensdauer der leistungselektronischen Module weiter verlängert und zum anderen auch die elektrische Funktionalität noch verbessert werden kann. Die bisher eingesetzten Ätzverfahren ermöglichen keine derart feine Strukturierung. Dies wird erst mit der vorgeschlagenen Bearbeitung mit einem oder mehreren Laserstrahlen erreicht. Durch die Laserbearbeitung lassen sich feinste Strukturen mit sehr hoher Präzision erzeugen.

In der ersten Verfahrensalternative wird diese Möglichkeit der feinen Strukturierung genutzt, um den Schaltungsträger, also z.B. das keramische Substrat und/oder die auf dem keramischen Substrat aufgebrachte Metallisierung, so zu strukturieren, dass bei der Herstellung oder beim Betrieb des leistungselektronischen Moduls auftretende thermomechanische Spannungen verringert werden. Dies gilt in gleicher Weise für die Erzeugung von Strukturen in einer eventuell vorhandenen Bodenplatte. Die Strukturierung kann hierbei über der jeweiligen Fläche gleichmäßig, ungleichmäßig, mit beliebigen Geometrien, beispielsweise als Löcher oder als Gräben, erfolgen. Die für das jeweilige leistungselektronische Modul zur Verringerung der thermomechanischen Spannungen geeigneten Strukturen können vorab über eine Simulation ermittelt werden. Vorzugsweise erfolgt die Strukturierung durch Erzeugung von Vertiefungen, von denen eine oder mehrere eine Breite von weniger als 50 µm aufweisen. Diese feine Strukturierung lässt sich beispielsweise über größere Bereiche der Metallisierung, also der vorderseitigen und/oder der rückseitigen Metallisierung des leistungselektronischen Schaltungsträgers, erzeugen, ohne die elektrische Funktionalität des leistungselektronischen Moduls dadurch zu beeinträchtigen.

Die Strukturierung kann bei dem vorgeschlagenen Verfahren so erfolgen, dass sie sich wenigstens zum Teil in Bereiche erstreckt, die sich nach Fertigstellung des leistungselektronischen Moduls unterhalb eines oder mehrerer der Halbleiterbauteile des leistungselektronischen Moduls befindet. Durch diese Möglichkeit der Ausnutzung größerer Flächen der Metallisierung können thermomechanische Spannungen besser verringert werden als bei Erzeugung von Strukturen nur an Rändern des Schaltungsträgers. Durch eine Strukturierung unter dem Halbleiterbauteil wird auch die Anbindung dieses Bauteils an den Schaltungsträger verbessert, die in der Regel mit Hilfe einer Verbindungsschicht erfolgt.

In einer weiteren Ausgestaltung kann die Strukturierung auch umlaufend oder teilumlaufend um Bereiche in der Metallisierung erfolgen, auf die im weiteren Verlauf des Fertigungsprozesses einzelne Halbleiterbauteile aufgebracht werden (Bauelement-Zielstellen). Auf diese Weise lassen sich beispielsweise auch Lötstoppgräben sowie Barrieren für ein ungewolltes Verschwimmen von Bauteilen beim Verbindungsprozess oder ein ungewolltes Verteilen von Verbindungsmaterial erzeugen. Weiterhin besteht auch die Möglichkeit, mit dem Laserstrahl geeignete feine Strukturen am Rand der Metallisierungen zu erzeugen, die die Gefahr eines Ablösens der Metallisierung an den Rändern verringern.

In der zweiten Verfahrensalternative werden der oder die Laserstrahlen genutzt, um entweder eine Strukturierung der Metallisierung zur Ausbildung von Leiterbahnen oder auch elektrischen Bauelementen zu erzeugen oder um eine bereits - beispielsweise durch ein vorangegangenes Ätzverfahren - vorliegende Strukturierung noch zu verfeinern oder zu ergänzen. Hierbei wird ausgenutzt, dass durch den Materialabtrag mit einem Laserstrahl sehr präzise Strukturen erzeugt werden können, die die elektrische Funktionalität der Metallisierung durch die höhere Präzision verbessern oder sogar ergänzen. Die Strukturierung kann hierbei durch lokalen Materialabtrag über die gesamte Dicke Metallisierungsschicht (lokale Entfernung der Metallisierung) oder auch nur durch lokales Dünnen der Metallisierungsschicht erfolgen. So lassen sich beispielsweise durch entsprechende Längsstrukturierung einer bereits vorliegenden Leiterbahn Abschirmungen für die Leiterbahn erzeugen. Auch eine lokale Steigerung des Widerstands durch Verjüngung einer Leiterbahn oder durch lokale Dünnung der Metallschicht der Leiterbahn ist dadurch mit hoher Präzision möglich. Schließlich besteht auch die Möglichkeit, durch lokalen Materialabtrag mit dem Laserstrahl eine Planarspule oder auch einen Kondensator in der Metallisierung zu erzeugen. Prinzipiell lässt sich die gesamte Strukturierung der Metallisierung alleine durch die Laserbearbeitung erzeugen. Es kann jedoch auch eine bereits durch ein anderes Verfahren, insbesondere Ätzen, erzeugte Strukturierung durch zusätzliche Laserbearbeitung entsprechend ergänzt oder verfeinert werden.

Ein mit dem vorgeschlagenen Verfahren herstellbares leistungselektronisches Modul weist entsprechend ein oder mehrere Halbleiterbauelemente auf einer Vorderseite eines leistungselektronischen Schaltungsträgers, bspw. eines keramischen Substrats, auf, der eine vorderseitig oder eine vorder- und rückseitig aufgebrachte Metallisierung trägt. Der leistungselektronische Schaltungsträger und/oder die auf dem leistungselektronischen Schaltungsträger aufgebrachte Metallisierung und/oder eine mit der Rückseite des leistungselektronischen Schaltungsträgers ggf. verbundene Bodenplatte weist hierbei in einer Ausgestaltung des Moduls eine durch lokalen Materialabtrag mit Laserstrahlung erzeugte Struktur auf, durch die bei der Herstellung oder beim Betrieb des leistungselektronischen Moduls auftretende thermomechanische Spannungen verringert werden. Diese Struktur ist durch eine oder mehrere Vertiefungen gekennzeichnet, von denen eine oder mehrere vorzugsweise eine Breite von weniger als 50 µm aufweisen.

In einer alternativen Ausgestaltung des leistungselektronischen Moduls ist die vorderseitig auf dem leistungselektronischen Schaltungsträger aufgebrachte Metallisierung durch lokalen Materialabtrag mit Laserstrahlung strukturiert oder teilstrukturiert, um eine vorgegebene elektrische Funktionalität der Metallisierung zu erreichen. Beide Ausgestaltungen können auch miteinander kombiniert sein.

Das vorgeschlagene Verfahren lässt sich bei der Herstellung leistungselektronischer Module einsetzen, um deren elektrische Funktionalität und/oder Lebensdauer zu steigern. Beispiele für derartige leistungselektronische Module sind Umrichter, Wechselrichter, Transformatoren, Schaltnetzteile oder Verstärker. Das Verfahren ist unabhängig von der jeweiligen Anwendung des leistungselektronischen Moduls einsetzbar.

### Kurze Beschreibung der Zeichnungen

Das vorgeschlagene Verfahren und zugehörige leistungselektronische Module werden nachfolgend anhand von Ausführungsbeispielen in Verbindung mit den Zeichnungen nochmals näher erläutert. Hierbei zeigen:
- Fig. 1: einen schematischen Aufbau eines beispielhaften leistungselektronischen Moduls des Standes der Technik;
- Fig. 2: ein Beispiel für eine Feinstrukturierung des Schaltungsträgers eines leistungselektronischen Moduls gemäß dem vorgeschlagenen Verfahren;
- Fig. 3: ein weiteres Beispiel für eine Feinstrukturierung des Schaltungsträgers eines leistungselektronischen Moduls gemäß dem vorgeschlagenen Verfahren; und
- Fig. 4: ein Beispiel für eine zusätzliche Strukturierung der bereits strukturierten vorderseitigen Metallisierung gemäß dem vorgeschlagenen Verfahren.

### Wege zur Ausführung der Erfindung

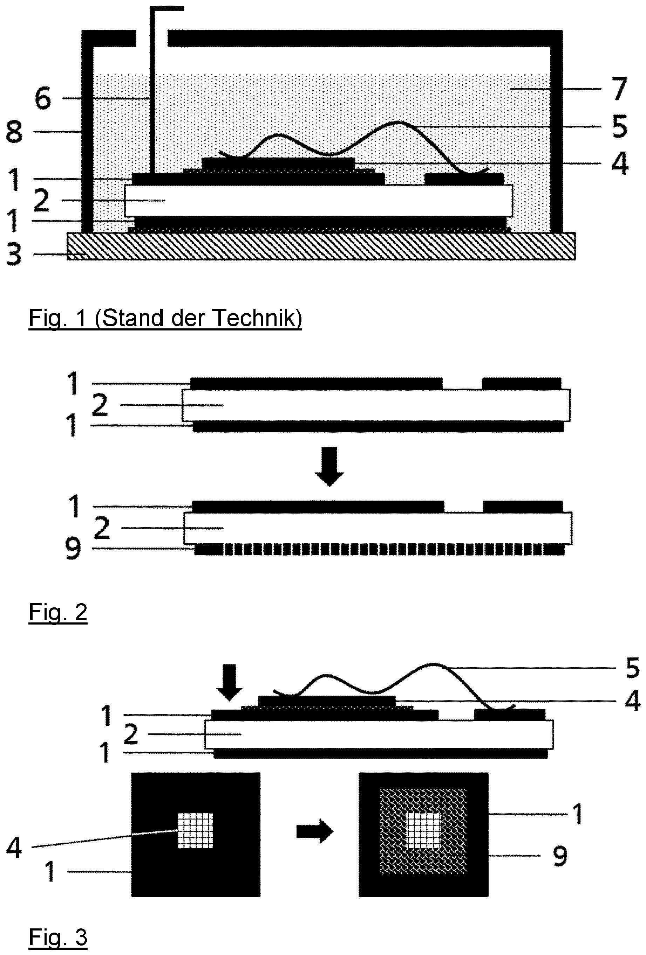

Das vorgeschlagene Verfahren befasst sich mit Maßnahmen zur Verlängerung der Lebensdauer und/oder Verbesserung der Funktionalität leistungselektronischer Module. Fig. 1 zeigt hierzu in schematischer Darstellung ein Beispiel für den bekannten Aufbau eines leistungselektronischen Moduls, das in diesem Beispiel nur ein Halbleiterbauelement 4 in Form eines Halbleiterchips aufweist. Das Halbleiterbauelement 4 ist über eine in der Figur erkennbare Verbindungsschicht mit der vorderseitigen Metallisierung 1 des leistungselektronischen Schaltungsträgers verbunden. Der leistungselektronische Schaltungsträger ist ein keramisches Substrat 2 mit beidseitiger Metallisierung 1 und an seiner Rück- bzw. Unterseite über eine in der Figur erkennbare Verbindungsschicht mit einer Bodenplatte 3 verbunden. Die vorderseitige Metallisierung 1, auf der sich das Halbleiterbauelement 4 befindet, ist geeignet strukturiert, um die gewünschte elektrische Verschaltung des Halbleiterbauelementes 4 über den Bonddraht 5 und die externe Anschlusslasche 6 zu ermöglichen. Der gesamte Schaltungsträger mit dem Halbleiterbauelement 4 ist in einem dielektrischen Vergussmaterial 7 vergossen und wird von einem Gehäuse 8 umschlossen, wie dies aus der Figur 1 ersichtlich ist. Bei der Herstellung eines derartigen leistungselektronischen Moduls treten bei den Verbindungsprozessen des Halbleiterbauelementes 4 mit dem Schaltungsträger bzw. des Schaltungsträgers mit der Bodenplatte 3 thermomechanische Spannungen auf, die zu einer Verbiegung des Schaltungsträgers, beispielsweise beim Auflöten des Halbleiterbauelementes, oder des gesamten leistungselektronischen Moduls, beispielsweise beim Auflöten des mit Halbleiterbauelementen bestückten Schaltungsträgers auf die Bodenplatte, führen.

Diese thermomechanischen Spannungen können durch Strukturierung des keramischen Substrates 2, der vorderseitigen und/oder rückseitigen Metallisierung 1 oder auch der Bodenplatte 3 verringert werden. Im dem in Figur 2 schematisch dargestellten Beispiel erfolgt diese Verringerung der thermomechanischen Spannungen durch Feinstrukturierung der rückseitigen Metallisierung 1 des Keramiksubstrats 2 mittels Laserstrahlung. Hierzu werden in der rückseitigen Metallisierung mit einem Laserstrahl in diesem Beispiel feine Gräben mit einer Grabenbreite von < 50 µm und einem geringen Abstand über nahezu die gesamte Fläche der rückseitigen Metallisierung eingebracht. Die sich ergebende strukturierte Metallisierung 9 ist in der Querschnittsdarstellung des Schaltungsträgers in Figur 2 zu erkennen. Die Form dieser Laserstrukturierung, gleichmäßig oder ungleichmäßig längs, quer, tief usw., die für das jeweilige Leistungsmodul am besten geeignet ist, kann vorab durch Simulationsrechnungen ermittelt werden.

Figur 3 zeigt ein weiteres Beispiel einer Feinstrukturierung der Metallisierung 1 des Schaltungsträgers mittels Laserstrahlung. In diesem Beispiel wird die vorderseitige Metallisierung 1 durch die Laserstrahlung fein strukturiert. Im oberen Teil der Figur 3 ist ein Querschnitt durch den Schaltungsträger mit darauf aufgebrachtem Halbleiterbauelement 4 und Bonddraht 5 (vgl. auch Figur 1) zu erkennen. Der untere Teil der Figur 3 zeigt in Draufsicht auf der linken Seite das Halbleiterbauelement 4 auf der vorderseitigen Metallisierung 1 ohne Strukturierung und auf der rechten Seite die Verhältnisse bei Einbringung der feinen Strukturierung 9 in diese vorderseitige Metallisierung gemäß dem vorliegenden Verfahren. Die Strukturierung 9 wird dabei vor dem Aufbringen des Halbleiterbauelements 4 in der Metallisierung 1 erzeugt und erstreckt sich in diesem Beispiel auch unterhalb des Halbleiterbauelementes 4.

Diese Strukturierung 9, wie sie in den Figuren 2 und 3 beispielhaft dargestellt ist, führt zu einer Erhöhung der Lebensdauer des leistungselektronischen Moduls, da thermomechanische Spannungen, wie sie bei der Herstellung des Leistungsmoduls und auch beim späteren Betrieb bei Lastwechseln oder bei Wechsel der Umgebungsbedingungen auftreten, verringert werden. Daraus resultiert ein geringerer Verschleiß des leistungselektronischen Moduls. Die mit dem Laserstrahl erzeugte Struktur selbst muss dabei nicht die gesamte Dicke der Metallisierung durchdringen (wie bei Figur 2), sondern kann sich auch nur über einen geringeren Dickenbereich dieser Metallisierung erstrecken.

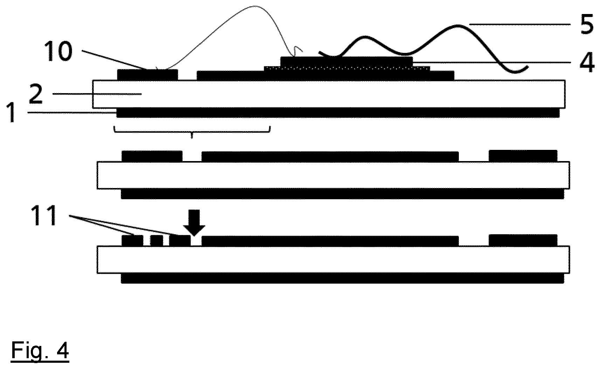

Figur 4 zeigt schließlich noch ein weiteres Beispiel der Durchführung des vorgeschlagenen Verfahrens, in diesem Fall zur Steigerung der elektrischen Funktionalität des leistungselektronischen Moduls. Bei leistungselektronischen Modulen kann es zu einer parasitären Kopplung von elektrischen Leiterbahnen auf dem keramischen Substrat kommen, wie sie durch Strukturierung der vorderseitigen Metallisierung erhalten werden. Eine derartige parasitäre Kopplung ist beispielsweise bei der Gateleitung 10 eines Halbleitertransistors als Halbleiterbauelement 4 unerwünscht. Figur 4 zeigt hierzu im Querschnitt im oberen Teil zunächst einen entsprechenden Schaltungsträger mit vorder- und rückseitiger Metallisierung 1, bei dem die vorderseitige Metallisierung auf dem keramischen Substrat 2 bereits entsprechend zur Bildung der Gateleitung 10 strukturiert wurde. Mit dem vorgeschlagenen Verfahren kann diese beispielsweise durch Ätzen erzeugte Struktur noch weiter verfeinert werden, um eine Abschirmung der Gateleitung 10 zu ermöglichen. Hierzu wird die vorhandene Leiterbahn, die die Gateleitung 10 bildet, durch lasergestützten Materialabtrag so strukturiert, dass beidseitig der dann schmaleren Gateleitung 10 zwei Leiterbahnen 11 verlaufen, die durch Verbindung mit einem geeigneten elektrischen Potential der Abschirmung der Gateleitung 10 dienen. Dies ist im unteren Teil der Figur 4 dargestellt.

Es besteht auch die Möglichkeit, zusätzlich durch Teilabtrag (Dünnung) der in der Mitte verlaufenden Gateleitung 10 einen Aufbau zu erzeugen, bei dem ein metallischer Deckel über der Gateleitung 10 angebracht (z.B. gelötet oder gebondet) werden kann, der auf den beiden Leiterbahnen 11 aufliegt. Die Möglichkeit zur Erzeugung derartiger Abschirmleitungen und damit einer zusätzlichen Funktionalität des leistungselektronischen Moduls wird erst durch die Nutzung des lasergestützten Materialabtrags ermöglicht, da nur durch diese Bearbeitung mit einem Laserstrahl die erforderliche feine Strukturierung und eine ausreichend hohe Präzision erreicht werden können.

### Bezugszeichenliste

- 1: Metallisierung bzw. Leiterbahn
- 2: Keramiksubstrat
- 3: Bodenplatte
- 4: Halbleiterbauelement
- 5: Bonddraht
- 6: externe Anschlusslasche
- 7: dielektrisches Vergussmaterial
- 8: Gehäuse
- 9: Strukturierung bzw. strukturierte Metallisierung
- 10: Gateleitung
- 11: Leiterbahnen zur Abschirmung

## Patentansprüche

1. Verfahren zur Steigerung der elektrischen Funktionalität und/oder Lebensdauer von leistungselektronischen Modulen, die ein oder mehrere Halbleiterbauelemente (4) auf einer Vorderseite eines leistungselektronischen Schaltungsträgers (2) aufweisen, der eine vorderseitig oder eine vorder- und rückseitig aufgebrachte Metallisierung (1) trägt, bei dem bei der Herstellung der leistungselektronischen Module
- der leistungselektronische Schaltungsträger (2) und/oder die auf dem leistungselektronischen Schaltungsträger (2) aufgebrachte Metallisierung (1) und/oder eine mit einer Rückseite des leistungselektronischen Schaltungsträgers (2) oder der darauf aufgebrachten Metallisierung (1) verbundene oder zu verbindende Bodenplatte (3) durch lokalen Materialabtrag mit wenigstens einem Laserstrahl strukturiert wird, um bei der Herstellung oder beim Betrieb des leistungselektronischen Moduls auftretende thermo-mechanische Spannungen zu verringern,
und/oder
- die vorderseitig auf dem leistungselektronischen Schaltungsträger (2) aufgebrachte Metallisierung (1) durch lokalen Materialabtrag mit wenigstens einem Laserstrahl strukturiert oder eine bereits in der vorderseitig auf dem leistungselektronischen Schaltungsträger (2) aufgebrachten Metallisierung (1) erzeugte Struktur (10) verfeinert oder ergänzt wird, um eine vorgegebene elektrische Funktionalität der Metallisierung (1) zu erreichen.

2. Verfahren nach Anspruch 1,
**dadurch gekennzeichnet,**
**dass** die Strukturierung durch Erzeugung von Vertiefungen erfolgt, von denen eine oder mehrere eine Breite von < 50 µm aufweisen.

3. Verfahren nach Anspruch 1 oder 2,
**dadurch gekennzeichnet,**
**dass** die Strukturierung bei einer vorder- und rückseitig aufgebrachten Metallisierung (1) wenigstens zum Teil in der rückseitig aufgebrachten Metallisierung (1) erfolgt.

4. Verfahren nach einem der Ansprüche 1 bis 3,
**dadurch gekennzeichnet,**
**dass** die Strukturierung wenigstens zum Teil in der vorderseitig aufgebrachten Metallisierung (1) erfolgt und sich in Bereiche erstreckt, die sich nach Fertigstellung des leistungselektronischen Moduls unterhalb eines oder mehrerer der ein oder mehreren Halbleiterbauelemente (4) befinden.

5. Verfahren nach einem der Ansprüche 1 bis 3,
**dadurch gekennzeichnet,**
**dass** die Strukturierung wenigstens zum Teil in der vorderseitig aufgebrachten Metallisierung (1) derart erfolgt, dass sie jeweils einzelne Bereiche wenigstens zum Teil umschließt, über denen sich nach Fertigstellung des leistungselektronischen Moduls jeweils eines der ein oder mehreren Halbleiterbauelemente (4) befindet.

6. Verfahren nach einem der Ansprüche 1 bis 5,
**dadurch gekennzeichnet,**
**dass** die Strukturierung wenigstens zum Teil an Rand der Metallisierung (1) erfolgt.

7. Verfahren nach einem der Ansprüche 1 bis 6,
**dadurch gekennzeichnet,**
**dass** in der vorderseitig auf dem leistungselektronischen Schaltungsträger (2) aufgebrachten Metallisierung (1) durch den lokalen Materialabtrag elektrische Bauelemente, insbesondere in Form einer oder mehrerer Planarspulen und/oder eines oder mehrerer Kondensatoren, gebildet werden.

8. Verfahren nach einem der Ansprüche 1 bis 7,
**dadurch gekennzeichnet,**
**dass** ein oder mehrere in der vorderseitig auf dem leistungselektronischen Schaltungsträger (2) aufgebrachten Metallisierung (1) erzeugte Leiterbahnen durch den lokalen Materialabtrag lokal gedünnt oder verjüngt werden, um deren elektrischen Widerstand zu erhöhen.

9. Verfahren nach einem der Ansprüche 1 bis 8,
**dadurch gekennzeichnet,**
**dass** ein oder mehrere in der vorderseitig auf dem leistungselektronischen Schaltungsträger (2) aufgebrachten Metallisierung (1) erzeugte Leiterbahnen durch den lokalen Materialabtrag in drei nebeneinander verlaufende Bahnen aufgetrennt werden, um eine elektrische Abschirmung zu ermöglichen.

10. Leistungselektronisches Modul mit einem oder mehreren Halbleiterbauelementen (4) auf einer Vorderseite eines leistungselektronischen Schaltungsträgers (2), der eine vorderseitig oder eine vorder- und rückseitig aufgebrachte Metallisierung (1) trägt,
bei dem der leistungselektronische Schaltungsträger (2) und/oder die auf dem leistungselektronischen Schaltungsträger (2) aufgebrachte Metallisierung (1) und/oder eine mit einer Rückseite des leistungselektronischen Schaltungsträgers (2) oder der darauf aufgebrachten Metallisierung (1) verbundene Bodenplatte (3) eine durch lokalen Materialabtrag mit wenigstens einem Laserstrahl erzeugte Struktur (9) aufweist, durch die bei der Herstellung oder beim Betrieb des leistungselektronischen Moduls auftretende thermo-mechanische Spannungen verringert werden.

11. Leistungselektronisches Modul mit einem oder mehreren Halbleiterbauelementen (4) auf einer Vorderseite eines leistungselektronischen Schaltungsträgers (2), der eine vorderseitig oder eine vorder- und rückseitig aufgebrachte Metallisierung (1) trägt,
bei dem die vorderseitig auf dem leistungselektronischen Schaltungsträger (2) aufgebrachte Metallisierung (1) durch lokalen Materialabtrag mit wenigstens einem Laserstrahl strukturiert oder teilstrukturiert ist, um eine vorgegebene elektrische Funktionalität der Metallisierung zu erreichen.

12. Leistungselektronisches Modul nach Anspruch 10, **dadurch gekennzeichnet,**
**dass** die mit dem Laserstrahl erzeugte Struktur (9) eine oder mehrere Vertiefungen mit einer Breite von < 50 µm aufweist.

13. Leistungselektronisches Modul nach Anspruch 10 oder 12, **dadurch gekennzeichnet,**
**dass** die mit dem Laserstrahl erzeugte Struktur (9) bei einer vorder- und rückseitig aufgebrachten Metallisierung (1) wenigstens zum Teil in der rückseitig aufgebrachten Metallisierung (1) vorliegt.

14. Leistungselektronisches Modul nach einem der Ansprüche 10, 12 oder 13,
**dadurch gekennzeichnet,**
**dass** die mit dem Laserstrahl erzeugte Struktur (9) wenigstens zum Teil in der vorderseitig aufgebrachten Metallisierung (1) vorliegt und sich in Bereiche erstreckt, die sich unterhalb eines oder mehrerer der ein oder mehreren Halbleiterbauelemente (4) befinden.

15. Leistungselektronisches Modul nach einem der Ansprüche 10, 12 oder 13,
**dadurch gekennzeichnet,**
**dass** die mit dem Laserstrahl erzeugte Struktur (9) wenigstens zum Teil in der vorderseitig aufgebrachten Metallisierung (1) vorliegt und derart ausgebildet ist, dass sie jeweils einzelne Bereiche wenigstens zum Teil umschließt, über denen sich jeweils eines der ein oder mehreren Halbleiterbauelemente (4) befindet.

16. Leistungselektronisches Modul nach Anspruch 11,
**dadurch gekennzeichnet,**
**dass** eine durch den lokalen Materialabtrag mit dem Laserstrahl in der vorderseitigen Metallisierung erhaltene Struktur ein oder mehrere elektrische Bauelemente bildet, insbesondere in Form einer oder mehrerer Planarspulen und/oder eines oder mehrerer Kondensatoren.

17. Leistungselektronisches Modul nach einem der Ansprüche 11 oder 16,
**dadurch gekennzeichnet,**
**dass** eine durch den lokalen Materialabtrag mit dem Laserstrahl in der vorderseitigen Metallisierung erhaltene Struktur wenigstens eine zwischen zwei äußeren Leiterbahnen (11) verlaufende innere Leiterbahn bildet, bei der die zwei äußeren Leiterbahnen (11) die innere Leiterbahn elektrisch abschirmen.
